# EUROPÄISCHE PATENTSCHRIFT

(11) **EP 1 445 843 B1**
(45) Veröffentlichungstag und Bekanntmachung des Hinweises auf die Patenterteilung: **20.09.2006**
(21) Anmeldenummer: 03360020.6
(22) Anmeldetag: 05.02.2003
(51) Int. Cl.: H01S 5/042

(54) **Ansteuerschaltung und Verfahren zum Betreiben eines Halbleiterlasers**
Driver and operation method for semiconductor lasers
Circuit et méthode d'opération d'un laser à semiconducteur

(43) Veröffentlichungstag der Anmeldung: 11.08.2004
(73) Patentinhaber: ALCATEL, 75008 Paris (FR)
(72) Erfinder: Preisach, Helmut, 74354 Besigheim (DE)
(74) Vertreter: Urlichs, Stefan

(56) Entgegenhaltungen:
- EP-A- 1 261 082
- US-A1- 2002 085 599
- PATENT ABSTRACTS OF JAPAN vol. 2000, no. 04, 31. August 2000 (2000-08-31) & JP 2000 031760 A (MATSUSHITA ELECTRIC IND CO LTD), 28. Januar 2000 (2000-01-28)
- PATENT ABSTRACTS OF JAPAN vol. 1999, no. 13, 30. November 1999 (1999-11-30) & JP 11 233876 A (SUMITOMO ELECTRIC IND LTD), 27. August 1999 (1999-08-27)
- PATENT ABSTRACTS OF JAPAN vol. 1998, no. 10, 31. August 1998 (1998-08-31) & JP 10 145221 A (TOSHIBA CORP), 29. Mai 1998 (1998-05-29)

## Beschreibung

Die vorliegende Erfindung betrifft eine Ansteuerschaltung für und ein Verfahren zum Betreiben eines Halbleiterlasers, insbesondere eines Vertical Cavitiy Surface Emitting Laser (VCSEL).

Die erfindungsgemäße Ansteuerschaltung ist insbesondere geeignet für die Ansteuerung von unterschiedlichen Arten von VCSEL, d.h. VCSEL mit unterschiedlicher Charakteristik.

VCSEL sind Halbleiterlaserdioden, die ihr Licht vertikal zur Oberfläche des Wafers emittieren. Diese haben im Vergleich mit anderen Halbleiterlasern viele Vorteile. Zu nennen sind beispielsweise die sehr hohen Modulationsraten, der sehr geringe Leistungsverbrauch, ein hoher Wirkungsgrad für die optische Kopplung mit Lichtleitern, sowie photolithografisch definierte Geometrien. Außerdem sind VCSEL sehr kostengünstig. Im Vergleich zu DFB-Lasern beträgt der Kostenfaktor beispielsweise ca. 100. VCSEL weisen allerdings eine begrenzte Ausgangsleistung und eine starke Temperaturabhängigkeit auf. Einsatzbereiche für VCSEL sind beispielsweise 10 Gbit Ethernetnetzwerke, In-Office-Systemen aber auch Übertragungssysteme im Kurzstreckenbereich wie Metronetzwerke. Seit längerem bekannt sind VCSEL mit einer Laserwellenlänge im Bereich von 850 nm. In jüngster Zeit werden auch VCSEL mit einer Laserwellenlänge von 1300 nm vertrieben. Im Gegensatz zu DFB-Lasern, die üblicherweise im Dauerstrichbetrieb betrieben und deren Laserlicht zu Nachrichtenübertragung über einen externen nachgeschalteten Modulator moduliert wird, werden VCSEL direkt moduliert.

Bekannt ist eine Schaltung zur Ansteuerung eines VCSEL mit 850 nm Emissionswellenlänge, die ein Differenzverstärker ist, wie z.b. in US 2002 0085599. Dabei ist ein Anschluss des VCSEL mit Masse und der andere Anschluss des VCSEL mit einem Ausgang des Differenzverstärkers verbunden. Eine solche Beschaltung bezeichnet man auch als "single-ended". Mittels des Differenzverstärkers wird der VCSEL direkt moduliert betrieben. VCSEL mit einer Emissionswellenlänge von 850 nm weisen eine relativ hohe Schwellspannung von ca. 1,8 V, einen Schwellstrom von ca. 3 mA und einen Grenzstrom von ca. 10 mA auf. Ihr differentiellen Widerstand liegt in der Größenordnung von 60 Ω. Zur Vermeidung von Verzerrungen ist die Verbindungsleitung zwischen Ansteuerschaltung und VCSEL-Chip üblicherweise an den differentiellen Widerstand des VCSEL angepasst.

Die in jüngster Zeit entwickelten VCSEL mit einer Emissionswellenlänge von 1300 nm besitzen eine Schwellspannung von 1,3 V, jedoch einen differentiellen Widerstand in der Größenordnung von 120 Ω. Im Gegensatz zu Verbindungsleitungen mit einer Impedanz von 120 Ω ist die Verwendung von Verbindungsleitungen mit einer Impedanz von 55 - 85 Ω unter technischen und wirtschaftlichen Gesichtpunkten unproblematisch. Die vorstehend beschriebene Ansteuerschaltung des Standes der Technik hat den Nachteil, dass diese - wenn überhaupt nur eingeschränkt - für VCSEL mit hohem differentiellen Widerstand einsetzbar ist.
Demgegenüber liegt der Erfindung die Aufgabe zugrunde, eine Schaltung und ein Verfahren zur Ansteuerung eines Halbleiters zu schaffen, mit der ein Halbleiterlaser mit hohem differentiellen Widerstand direkt moduliert angesteuert wird.

Der Erfindung liegt weiterhin die Aufgabe zugrunde, eine Schaltung und ein Verfahren zu schaffen, welche auch für die Ansteuerung von Halbleiterlasern mit geringerem differentiellen Widerstand einsetzbar sind.

Zur Lösung dieser Aufgabe wird zum einen eine Schaltung mit den Merkmalen des Anspruches 1, zum anderen ein Verfahren mit den Merkmalen des Anspruches 9 vorgeschlagen.

Weitere Vorteile und Ausgestaltungen der Erfindung ergeben sich aus den Unteransprüchen, aus der Beschreibung und der beiliegenden Zeichnung.

Es versteht sich, dass die vorstehenden genannten und die nachstehend noch zu erläuternden Merkmale nicht nur in der jeweils angegebenen Kombination, sondern auch in anderen Kombinationen oder in Alleinstellung verwendbar sind, ohne den Rahmen der vorliegenden Erfindung zu verlassen.

Die Erfindung ist anhand eines Ausführungsbeispieles in den Zeichnungen dargestellt und wird im folgenden unter Bezugnahme auf die Zeichnungen näher erläutert.
Figur 1 zeigt eine schematische Darstellung einer Schaltung zur Ansteuerung eines Halbleiterlasers des Standes der Technik,
Figur 2 zeigt eine schematische Darstellung einer ersten Ausführungsform einer erfindungsgemäßen Schaltung zur Ansteuerung eines Halbleiterlasers,
Figur 3 zeigt eine schematische Darstellung einer zweiten Ausführungsform der erfindungsgemäßen Schaltung zur Ansteuerung eines Halbleiterlasers und
Figur 4 zeigt eine schematische Darstellung einer dritten Ausführungsform der erfindungsgemäßen Schaltung zur Ansteuerung eines Halbleiterlasers.

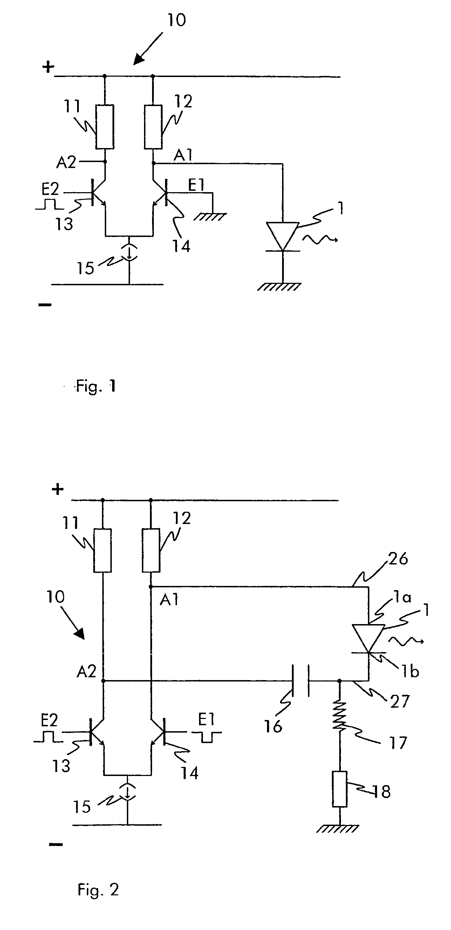

Figur 1 zeigt schematisch eine Ansteuerschaltung des Standes der Technik für eine direkte Modulation eines Halbleiterlasers, insbesondere in Form einer Halbleiterlaserdiode. Bezugszeichen 1 bezeichnet einen Vertical Cavitiy Surface Emitting Laser (VCSEL), dessen Kathode auf Masse geschaltet ist, wobei die Modulation des VCSEL über den Anodenanschluss erfolgt. Die Schaltung des Standes der Technik stellt einen bekannten Differenzverstärker 10 dar, der dem VCSEL 1 zur direkten Modulation vorgeschaltet ist. Der Differenzverstärker 10 ist ein symmetrischer Gleichspannungsverstärker mit zwei Eingängen E1, E2 und zwei Ausgängen A1, A2. Der Differenzverstärker umfasst zwei Widerstände 11, 12, zwei Transistoren 13, 14 und eine Konstantstromquelle 15, die in der gemeinsamen Emitterleitung der Transistoren 13, 14 angeordnet ist. Differenzverstärker sind dem Fachmann allgemein bekannt, und brauchen daher hier nicht näher erläutert werden. Wegen ihrer niedrigen Temperaturdrift werden Differenzverstärker vorzugsweise auch dann eingesetzt, wenn keine Spannungsdifferenz sondern nur eine Eingangsspannung verstärkt werden soll. In diesem Fall wird einer der beiden Eingänge E1 oder E2 auf Masse gelegt. In der Schaltung der Figur 1 ist der Eingang E1 auf Masse gelegt und die Ansteuerung des VCSEL 1 erfolgt über den Eingang E2 und den Ausgang A1, der mit der Anode des VCSEL 1 verbunden ist. Der Ausgang A1 ist nicht geschaltet. Wie in Figur 1 gezeigt wird der VCSEL 1 einseitig über einen Anschluss, nämlich die Anode angesteuert, während die Kathode auf Masse geschaltet ist. Eine solche Beschaltung bezeichnet man auch als "single-ended".

Figur 2 zeigt eine schematische Darstellung einer ersten Ausführungsform einer erfindungsgemäßen Treiber- bzw. Ansteuerschaltung für einen VCSEL 1, wobei der VCSEL 1 differentiell angesteuert ist. In Figur 2 bezeichnen gleiche Bezugszeichen gleiche Komponenten wie in Figur 1. Die erfindungsgemäße Schaltung ist vorzugsweise als Integrierte Schaltung (IC) oder Tei einer integrierten Schaltung ausgeführt. Nachfolgend wird die erfindungsgemäße Schaltung näher erläutert.
Die erfindungsgemäße Treiberschaltung der Figur 2 umfasst ebenfalls den Differenzverstärker 10, wobei jedoch beide Eingänge E1 und E2 und beide Ausgänge A1 und A2 zur differentiellen Ansteuerung des VCSEL 1 verwendet werden. Die Transistoren 13, 14 sind als bipolare Transistoren dargestellt. Für den Fachmann ist es offensichtlich, dass auch ein Differenzverstärker mit MOSFET-Transistoren verwendet werden kann. Der Ausgang A2 ist mit der Anode 1a des VCSEL 1 verbunden und der Ausgang A1 über einen Kondensator 16 mit der Kathode 1b des VCSEL 1. Zwischen Kondensator 16 und Kathode 1b des VCSEL 1 sind noch eine Spule 17 und ein Widerstand 18 in Reihe als Gleichstrompfad gegen Masse geschaltet. Der VCSEL 1 wird differentiell betrieben, d.h. die Widerstände 11 , 12 und die Stromquelle 15 sind so bestimmt, dass am VCSEL 1 eine Spannungsdifferenz von circa 1,5 V abfällt und über die Eingänge E1 und E2 werden Modulationsfrequenzen angelegt. Die Kathode des VCSEL 1 ist über den Kondensator 16 mit dem Ausgang A2 des Differenzverstärkers 10 wechselstromgekoppelt (AC-gekoppelt). Der Schaltungszweig Ausgang A1 des Differenzverstärkers 10, Anode 1a bzw. Kathode 1b des VCSEL 1 ist über die Spule 17 und den Widerstand 18 gleichstromgekoppelt (DCgekoppelt). Über diesen Zweig wird die Vorspannung zum Betreiben des VCSEL 10 aufgebracht wird. Der VCSEL 1 ist über impedanzangepasste Anschlussleitungen 26 und 27 mit der Schaltung verbunden.

Die erfindungsgemäße Ansteuerschaltung ist besonders vorteilhaft für die Ansteuerung eines VCSEL mit hohem differentiellem Widerstand.

Die bereits seit längerer Zeit in der Praxis eingesetzten VCSEL mit einer Emissionswellenlänge von 850 nm weisen eine relativ hohe Schwellspannung von ca. 1,8 V, einen Schwellstrom von ca. 3 mA und einen Grenzstrom von ca. 10 mA auf. Ihr differentiellen Widerstand liegt in der Größenordnung von 60 Ω. Auf Grund der starken Temperaturabhängigkeit von VCSEL strebt man an, die Integrierte Schaltung, die die Ansteuerschaltung umfasst, und den Chip mit dem VCSEL räumlich beabstandet anzuordnen. Die Abstände liegen üblicherweise im Zentimeterbereich. Die Verbindungsleitung der Ansteuerschaltung zum VCSEL-Chip ist zur Vermeidung von Verzerrungen üblicherweise so ausgelegt, dass der Wellenwiderstand abgeschlossen ist, d.h. diese ist an den differentiellen Widerstand des VCSEL angepasst. Verbindungsleitungen mit einer Impedanz von 55 bis 85 Ω sind unter wirtschaftlichen Gesichtpunkten mit vernünftigen Aufwand realisierbar und verfügbar.

Die in jüngster Zeit entwickelten VCSEL mit einer Emissionswellenlänge von 1300 nm besitzen eine Schwellspannung von 1,3 V, jedoch einen differentiellen Widerstand in der Größenordnung von 120 Ω. Verbindungsleitungen mit einer Impedanz von 120 Ω sind in Herstellung und Handhabung technisch aufwendig und somit nicht kostengünstig.

Durch die erfindungsgemäße Ansteuerschaltung mit differentielle Ansteuerung kann auch für VCSEL mit hohen differentiellen Widerstand der Wellenwiderstand der Ansteuer-/Verbindungsleitungen auf einfache Art und Weise abgeschlossen werden. Durch die zwei Verbindungsleitungen infolge der differentiellen Ansteuerung kann auch in diesem Fall ein Abschluss mit einfachen technischen Mitteln erzielt, d.h. die verfügbaren Leitungen mit einer Leitungsimpedanz in Bereich von 50 bis 85 Ω können eingesetzt werden.

Die erfindungsgemäße Schaltung der Figur 2 weist außerdem den Vorteil auf, dass der Kondensator 16, die Spule 17 und der Widerstand 18, die auch als Bias-T bezeichnet werden, durch die gewählte Schaltungsanordnung - nämlich der Verwendung eines gleichstromgekoppelten und eines wechselstromgekoppelten Zweiges zum Anschluss des VCSEL - derart dimensioniert sind, dass diese auf den IC, die die Ansteuerschaltung umfasst, integriert werden können. Größenordnungsmäßig weist der Kondensator 16 einen Wert von 2 pF, die Spule 17 einen Wert von 4,7 nH und der Widerstand eine Wert von 50 Ω auf. Dieses stellt einen erheblichen Vorteil für die Fertigung und den Betrieb der Schaltung dar. Die erfindungsgemäße Schaltung hat somit den Vorteil, dass der VCSEL nur im "hochfrequenten" Bereich differentiell betrieben wird, während im Gleichstrombereich zur Aufbringung der Vorspannung der VCSEL "quasi" "single-ended" angesteuert ist.

Die erfindungsgemäße Schaltung weist weiterhin den Vorteil auf, dass diese auch für die bekannten VCSEL mit geringerem differentiellen Widerstand einsetzbar ist.

Mit anderen Worten: Die Schaltung bzw. eignet sich nicht nur für die Ansteuerung eines VCSEL mit höherem differentiellen Widerstand, also beispielweise eines VCSEL mit 1300 nm Emissionswellenlänge und differentiellen Widerstand von ca. 120 Ω, wie zuvor beschrieben, sondern kann auch auf einfache Art und Weise für die bereits seit längerem bekannten VCSEL mit 850 nm Emissionswellenlänge und mit geringerem Widerstand von ca. 60 Ω verwendet werden. Zum Ansteuern eines 850 nm VCSEL wird lediglich ein Eingang, also E1 oder E2 auf ein konstantes Potential gelegt und die Kathode des VCSEL nicht über den Kondensator 16 mit dem Ausgang A2 verbunden, sondern einfach auf Masse gelegt, wodurch eine "single-ended" Ansteuerung des VCSEL erzielt wird.

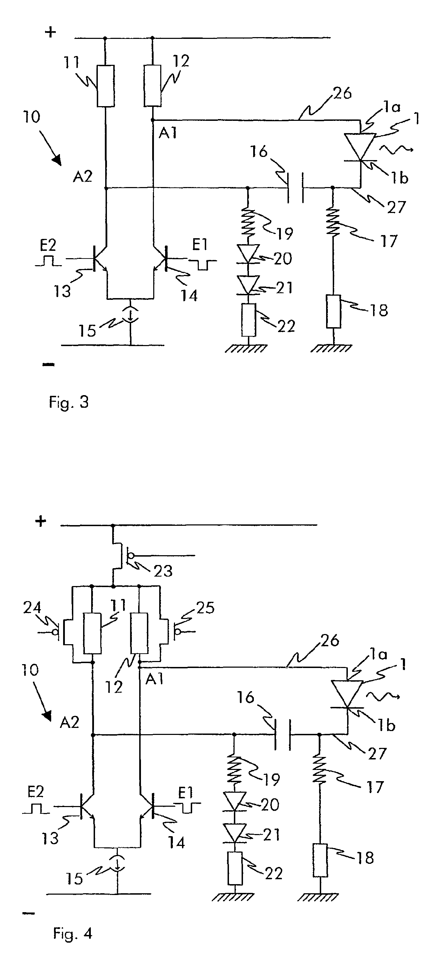

Figur 3 zeigt eine vorteilhafte Ausgestaltung der erfindungsgemäßen Schaltung der Figur 2. Aus Gründen der Symmetrie sind zwischen Ausgang A1 und Kondensator 16 eine Spule 19 und zwei Dioden 20, 21 über einen Widerstand 22 in Reihe gegen Masse geschaltet. Auf diese Art und Weise wird erreicht, dass die Arbeitspunkte auf beiden Seiten gleich sind, wodurch Verzerrungen vermieden werden.

Figur 4 zeigt eine weitere vorteilhafte Ausgestaltung der erfindungsgemäßen Treiberschaltung von Figur 3. Den parallel geschalteten Widerständen 11 und 12 im Kollektorzweig der Transistoren 13 und 14 ist ein Transistor 23 vorgeschaltet. Außerdem ist jedem Widerstand 11 und 12 ein weiterer Transistor 24 und 25 parallel geschaltet. Die in Figur 4 dargestellten Transistoren 23, 24 und 25 sind MOSFET-Transistoren. Die gezeigte Beschaltung der Widerstände ermöglicht auf vorteilhafte Weise eine variable Einstellung des Arbeitspunktes des Differenzverstärkers 10, indem entsprechenden Spannungen an das Gate der Transistoren 23, 24 und 25 angelegt werden.

Eine derart ausgestaltete erfindungsgemäße Treiberschaltung eignet sich insbesondere für eine automatische Einstellung bzw. Abstimmung der Ansteuerschaltung an die jeweils verwendeten VCSEL 1. Diese Abstimmung kann im Hinblick auf unterschiedlichste Faktoren erfolgen und wünschenswert sein, zum Beispiel für den Einsatz der Schaltung mit VCSEL, die bei unterschiedlicher Wellenlänge Laserlicht emittieren. Die Charakteristika bzw. Kennlinien unterscheiden sich dabei üblicherweise deutlich voneinander, so dass es in diesem Fall einer starken Anpassung bedarf. Die Abstimmung kann insbesondere aber auch im Hinblick auf die Verwendung der Schaltung in der "single-ended"-Betriebsart oder der differentiellen Betriebsart bzw. "dual-ended"-Betriebsart erfolgen. Die automatische Anpassung/Abstimmung der Schaltung kann weiterhin auch dafür vorgesehen sein, um weniger signifikante Abweichungen aufzufangen z.B. bei Verwendung baugleicher oder -ähnlicher VCSEL unterschiedlicher Hersteller oder für den Ausgleich von Herstellungstoleranzen eines bestimmten VCSEL. Die automatische Abstimmung kann schließlich auch der Anpassung an unterschiedliche Umgebungseinflüsse während des Betriebs des VCSEL, z.B. Temperatureinflüsse, dienen. In Abhängigkeit vom gewünschten Einsatzzweck ist somit ein entsprechend großer Abstimmbereich und eine entsprechende Abstimmgenauigkeit vorzusehen.

Bei einer weiteren bevorzugten Ausgestaltung der Erfindung sind zumindest für die Eingänge E1, E2 des Differenzverstärkers 10 und eines Steuereinganges der Konstantstromquelle 15 (nicht dargestellte) Digital-zu-Analog-Wandler vorgesehen. Auf diese Art und Weise können Einstellungen/Anpassungen der Schaltung bzw. die Ansteuerung des Halbleiterlasers mittel eines auf einen Mikroprozessor ausgeführten Programms durchgeführt werden. Der Mikroprozessor samt Ein/Ausgabebausteine und Speicher (RAM, ROM etc.) kann extern vorgesehen oder auf dem IC der Ansteuerschaltung sein. Bei einer bevorzugten Weiterbildung der Schaltung umfasst diese zumindest den (nicht dargestellten) Mikroprozessor zur Ausführung eines Programms zur Ansteuerung des Halbleiterlaser und/oder Einstellung der Schaltung.

Nachfolgend ist ein erfindungsgemäßes Verfahren zum Betreiben der Ansteuerschaltung beschrieben, bei dem die Schaltung an die jeweils verwendeten Halbleiterlaser angepasst wird. Die Anpassung der Schaltung wird durch vorgegebene Ereignisse ausgelöst. Vorgegebene Ereignisse sind z.B. eine erstmalige oder erneute Inbetriebnahme, ein Austausch des Halbleiterlasers, eine vorgegebene Anzahl von Betriebsstunden oder ein Auftreten einer Fehlfunktion.
Gemäß dem Verfahren werden
- mittels der Schaltung zunächst Kennliniendaten des Halbleiterlasers gemessen,
- aus den gemessenen Daten zumindest ein Startwerte der Schaltung ermittelt und eingestellt und
- durch Variation des Startwertes zumindest in Abhängigkeit von einer gewünschte Kenngröße, z.B. der Emissionsrate, des Halbleiterlasers Betriebswerte der Schaltung zum Betreiben der Schaltung mit diesem Halbleiterlaser ermittelt und eingestellt.

Nachfolgend ist das Verfahren zur automatischen Anpassung der Ansteuerschaltung an den jeweils angeschlossenen VCSEL genauer beschrieben. Als Startwert bzw. Parameter zum Einstellen der Schaltung ist beispielhaft der Steuerstrom vorgesehen. Es können aber andere Kenngrößen, z.B. Spannung, Temperatur etc., anstatt oder zusätzlich zur Einstellung herangezogen werden. Vorzugsweise wird die Schaltung bei Inbetriebnahme eingemessen bzw. die Kennlinie des VCSEL ausgemessen und die Schaltung an Hand der gewonnenen Messdaten eingestellt. Zu diesem Zweck ist die Schaltung mit dem zuvor beschriebenen (nicht dargestellten) Mikroprozessor verbunden, der ein Programm zur Erfassung der Charakteristik des VCSEL ausführt, verbunden. Der Mikroprozessor ist über entsprechende Ein-/Ausgabe-Bausteine und Digital-zu-Analog-Wandler mit den Eingängen E1, E2 der Transistoren 13 und 14, mit einem Steuereingang der Konstantstromquelle 15 und den Gate-Eingängen der Transistoren 23, 24 und 25 verbunden. Über einen Analog-zu-Digital-Wandler wird der Ausgang einer Monitordiode, die üblicherweise an einen Halbleiterlaser, z.B. VCSEL, vorhanden ist, dem Mikroprozessor zur Auswertung bereit gestellt. Zur Erfassung weiterer Kenndaten, z.B. der Temperatur, können entsprechende Sensoren und Schnittstellen vorgesehen sein.
Zur Einstellung/Anpassung der Schaltung wird vorzugsweise zunächst die Kennlinie des VCSEL gemessen. Dieses geschieht mit der Ansteuerschaltung, und zwar durch schrittweise Einstellung von geeigneten Stroms-/Spannungswerten, wobei äquidistante Schritte oder je nach Kennlinienbereich auch variable Schrittweiten vorgesehen sein können. Die ermittelten Kennlinien könne abgespeichert werden, z.B. zur späteren Auswertung, zur Protokollierung etc. Anschließend wird der maximale Steuerstrom eingestellt und die Emissionsrate mittels der Monitordiode gemessen. Dann wird die maximale Steuerstrom schrittweise erniedrigt und dabei der Strom für die gewünschte Emissionsrate mit der Monitordiode ermittelt. Der so ermittelte Arbeitspunkt wird abgespeichert und die Schaltungin auf diese Einstellung fixiert. Je nach den jeweiligen Anforderungen (Toleranzwerte etc.) können für bestimmte Halbleiterlaser auch deren Kennlinien bereits in einen Speicher hinterlegt sein, so dass auf eine Ermittlung der Kennlinie verzichtet werden kann.

Die Abstimmung der Treiberschaltung kann außerdem durch unterschiedliche Ereignisse gesteuert sein, z.B. die erstmalige Inbetriebnahme, den Wechsel eines Halbleiterlasers, z.B. eines VCSEL, die Anzahl der Betriebsstunden, das Auftreten einer Fehlfunktion usw. Außerdem können in dem Speicher bestimmte Konfigurationen der Treiber-/Ansteuerschaltung für bestimmte Typen von Halbleiterlasern und/oder Betriebsarten (dual-ended, single-ended) hinterlegt sein. Je nach Anforderung ist dann keine oder eine nur schnell durchzuführende Feinabstimmung notwendig. Außerdem kann vorgesehen sein, dass der Betrieb des Halbleiterlasers fortlaufend überwacht bzw. in kurzen Zeitabständen Messdaten des Halbleiterlasers ausgewertet werden, um so einen weitgehend optimierten Betrieb des Halbleiterlasers zu gewährleisten.

## Patentansprüche

1. Schaltung zur Ansteuerung eines Halbleiterlasers (1), insbesondere eines Vertical Cavitiy Surface Emitting Laser (VCSEL), mit einem Differenzverstärker (10) zur direkten Ansteuerung des Halbleiterlaser (1), **dadurch gekennzeichnet , dass** mittels des Differenzverstärkers (10) ein an die Schaltung anzuschließender Halbleiterlaser (1) differential angesteuert ist, wobei ein erster Ausgang (A1) des Differenzverstärkers (10) mit einem ersten Anschluss (1a) des Halbleiterlaser (1) gleichstromgekoppelt und ein zweiter Ausgang (A2) des Differenzverstärkers (10) mit einem zweiten Anschluss (1 b) des Halbleiterlaser (1) wechselstromgekoppelt verbunden ist.

2. Schaltung nach Anspruch 1, **dadurch gekennzeichnet, dass** der zweite Ausgang (A2) des Differenzverstärkers (10) mit dem zweiten Anschluss (1 b) des Halbleiterlaser (1) mittels eines Kondensators (16) verbunden ist, wobei zwischen Kondensator (16) und zweitem Anschluss (1 b) eine Spule (17) und ein Widerstand (18) in Reihe gegen Masse geschaltet sind.

3. Schaltung nach Anspruch 1 oder 2, **dadurch gekennzeichnet, dass** den Widerständen (11, 12) des Differenzverstärkers (10) einstellbare Widerstände (24, 25) parallel geschaltet sind.

4. Schaltung nach einem der Ansprüche 1 bis 3, **dadurch gekennzeichnet, dass** zwischen dem zweiten Ausgang (A2) des Differenzverstärkers (10) und dem Kondensator (16) eine Reihenschaltung von einer weiteren Spule (19), zweier Dioden (20, 21) und eines weiteren Widerstands (22) gegen Masse vorgesehen ist.

5. Schaltung nach einem der Ansprüche 1 bis 4, **dadurch gekennzeichnet, dass** Digital-zu-Analog-Wandler zumindest für die Eingänge (E1, E2) des Differenzverstärkers (10) und eines Steuereinganges der Konstantstromquelle (15) vorgesehen sind.

6. Schaltung nach Anspruch 5, **dadurch gekennzeichnet, dass** die Schaltung einen Mikroprozessor zur Ausführung eines Programms zur Ansteuerung des Halbleiterlaser (1) und/oder Einstellung der Schaltung umfasst.

7. Schaltung nach einem der Ansprüche 1 bis 5, **dadurch gekennzeichnet, dass** die Schaltung den Halbleiterlaser (1) umfasst, der insbesondere eine Halbleiterdiode ist, wobei die Anode der Laserdiode den ersten Anschluss (1a) des Halbleiterlasers (1) und die Kathode der Laserdiode den zweiten Anschluss (1 b) des Halbleiterlasers (1) darstellt.

8. Schaltung nach Anspruch 7, **dadurch gekennzeichnet, dass** die Schaltung und der Halbleiterlaser (1) auf räumlich getrennten Integrierten Schaltungen angeordnet sind, wobei impedanzangepasste Leitungen (26, 27) der Schaltung zum Anschließen des Halbleiterlaser (1) an die Schaltung vorgesehen sind.

9. Verfahren zum Betreiben einer Schaltung nach einem der Ansprüche 1 bis 8, **dadurch gekennzeichnet, dass** von vorgegebenen Ereignissen gesteuert die Schaltung an den verwendeten Halbleiterlaser (1) angepasst wird,
- wobei mittels der Schaltung zunächst Kennliniendaten des Halbleiterlasers (1) gemessen werden,
- aus den gemessenen Daten zumindest ein Startwerte der Schaltung ermittelt und eingestellt werden und
- durch Variation des Startwertes zumindest in Abhängigkeit von einer gewünschte Kenngröße des Halbleiterlasers Betriebswerte der Schaltung zum Betreiben der Schaltung mit diesem Halbleiterlaser (1) ermittelt und eingestellt werden.

10. Verfahren nach Anspruch 8, **dadurch gekennzeichnet, dass** zumindest eine erstmalige oder erneute Inbetriebnahme, ein Austausch des Halbleiterlasers (1), eine vorgegebene Anzahl von Betriebsstunden oder ein Auftreten einer Fehlfunktion ein Ereignis im Sinne der vorgegebenen Ereignisse darstellt.

## Claims

1. Circuit for driving a semiconductor laser (1), in particular a vertical cavity surface-emitting laser (VCSEL), comprising a differential amplifier (10) for driving the semiconductor laser (1) directly, **characterized in that** a semiconductor laser (1) to be connected to the circuit is differentially driven by means of the differential amplifier (10), a first output (A1) of the differential amplifier (10) being direct-current-coupled to a first terminal (1a) of the semiconductor laser (1) and a second output (A2) of the differential amplifier (10) being alternating-current-coupled to a second terminal (1b) of the semiconductor laser (1).

2. Circuit according to Claim 1, **characterized in that** the second output (A2) of the differential amplifier (10) is connected to the second terminal (1b) of the semiconductor laser (1) by means of a capacitor (16), a coil (17) and a resistor (18) being connected in series to chassis between the capacitor (16) and the second terminal (1b).

3. Circuit according to Claim 1 or 2, **characterized in that** variable resistors (24, 25) are connected in parallel with the resistors (11, 12) of the differential amplifier (10).

4. Circuit according to any one of Claims 1 to 3, **characterized in that** a series connection of a further coil (19), two diodes (20, 21) and a further resistor (22) connected to chassis is provided between the second output (A2) of the differential amplifier (10) and the capacitor (16).

5. Circuit according to any one of Claims 1 to 4, **characterized in that** digital-to-analogue converters are provided at least for the inputs (E1, E2) of the differential amplifier (10) and of a control input of the constant-current source (15).

6. Circuit according to Claim 5, **characterized in that** the circuit comprises a microprocessor for executing a program for driving the semiconductor laser (1) and/or setting the circuit.

7. Circuit according to any one of Claims 1 to 5, **characterized in that** the circuit comprises the semiconductor laser (1), which is, in particular, a semiconductor diode, the anode of the laser diode being the first terminal (1a) of the semiconductor laser (1) and the cathode of the laser diode being the second terminal (1b) of the semiconductor laser (1).

8. Circuit according to Claim 7, **characterized in that** the circuit and the semiconductor laser (1) are disposed on spatially separated integrated circuits, impedance-matched lines (26, 27) of the circuit being provided for connecting the semiconductor laser (1) to the circuit.

9. Method of operating a circuit according to any one of Claims 1 to 8, **characterized in that** the circuit is matched to the semiconductor laser (1) used under the control of specified events,
- wherein characteristic-curve data of the semiconductor laser (1) are first measured by means of the circuit,
- at least one start-up value of the circuit is determined and set on the basis of the measured data and
- circuit operating values for operating the circuit comprising said semiconductor laser (1) are determined and set by varying the start-up value at least as a function of a desired characteristic quantity of the semiconductor laser.

10. Method according to Claim 8, **characterized in that** at least an initial or repeat start-up, a replacement of the semiconductor laser (1), a specified number of operating hours or an occurrence of a fault is an event in the context of the specified events.

## Revendications

1. Circuit pour commander un laser en semiconducteur (1), notamment un VCSEL (Vertical cavity Surface Emitting Laser - Laser vertical à émission de surface par cavité), comprenant un amplificateur différentiel (10) pour la commande directe du laser en semiconducteur (1), **caractérisé en ce qu'**un laser en semiconducteur (1) à raccorder au circuit est commandé de manière différentielle au moyen de l'amplificateur différentiel (10), une première sortie (A1) de l'amplificateur différentiel (10) étant reliée par couplage en courant continu avec une première borne (1 a) du laser en semiconducteur (1) et une deuxième sortie (A2) de l'amplificateur différentiel (10) étant reliée par couplage en courant alternatif avec une deuxième borne (1b) du laser en semiconducteur (1).

2. Circuit selon la revendication 1, **caractérisé en ce que** la deuxième sortie (A2) de l'amplificateur différentiel (10) est reliée avec la deuxième borne (1b) du laser en semiconducteur (1) au moyen d'un condensateur (16), une bobine (17) et une résistance (18) étant branchées en série à la masse entre le condensateur (16) et la deuxième borne (1b).

3. Circuit selon la revendication 1 ou 2, **caractérisé en ce que** des résistances réglables (24, 25) sont branchées en parallèle avec les résistances (11, 12) de l'amplificateur différentiel (10).

4. Circuit selon l'une des revendications 1 à 3, **caractérisé en ce qu'**un circuit série composé d'une autre bobine (19), de deux diodes (20, 21) et d'une autre résistance (22) est branché à la masse entre la deuxième sortie (A2) de l'amplificateur différentiel (10) et le condensateur (16).

5. Circuit selon l'une des revendications 1 à 4, **caractérisé en ce que** des convertisseurs numérique/analogique sont prévus au moins pour les entrées (E1, E2) de l'amplificateur différentiel (10) et une entrée de commande de la source de courant constant (15).

6. Circuit selon la revendication 5, **caractérisé en ce que** le circuit comprend un microprocesseur pour exécuter un programme de commande du laser en semiconducteur (1) et/ou régler le circuit.

7. Circuit selon l'une des revendications 1 à 5, **caractérisé en ce que** le circuit comprend le laser en semiconducteur (1), lequel est notamment une diode en semiconducteur, l'anode de la diode laser représentant la première borne (1a) du laser en semiconducteur (1) et la cathode de la diode laser la deuxième borne (1b) du laser en semiconducteur (1).

8. Circuit selon la revendication 7, **caractérisé en ce que** le circuit et le laser en semiconducteur (1) sont disposés sur des circuits intégrés séparés dans l'espace, des lignes à l'impédance adaptée (26, 27) du circuit étant prévues pour la terminaison du laser en semiconducteur (1) au niveau du circuit.

9. Procédé pour faire fonctionner un circuit selon l'une des revendications 1 à 8, **caractérisé que** le circuit est adapté au laser en semiconducteur (1) utilisé en étant commandé par des événements prédéfinis,
- les données caractéristiques du laser en semiconducteur (1) étant tout d'abord mesurées au moyen du circuit,
- au moins une valeur de démarrage du circuit étant déterminée à partir des données mesurées puis réglées et
- les valeurs opérationnelles du circuit destinées au fonctionnement du circuit avec ce laser en semiconducteur (1) étant déterminées et réglées en faisant varier la valeur de démarrage au moins en fonction d'une grandeur caractéristique souhaitée du laser en semiconducteur.

10. Procédé selon la revendication 8, **caractérisé en ce qu'**au moins une première ou une nouvelle mise en service, un remplacement du laser en semiconducteur (1), un nombre prédéfini d'heures de service ou la survenance d'un défaut de fonctionnement représente un événement dans le sens des événements prédéfinis.
